# EUROPEAN PATENT APPLICATION

(11) **EP 4 676 194 A1**
(43) Date of publication of application: **07.01.2026**
(21) Application number: 25167991.6
(22) Date of filing: 02.04.2025
(51) Int. Cl.: H10F 77/30, H10F 10/16, H10F 77/70

(54) **SOLAR CELL AND PHOTOVOLTAIC MODULE**

(30) Priority: 03.07.2024 CN 202410884063
(71) Applicant: Longi Green Energy Technology Co., Ltd., Xi'an, Shaanxi 710100 (CN)
(72) Inventor: Zhang, Zelin, XI'AN, Shaanxi 710100 (CN); Yao, Weiran, XI'AN, Shaanxi 710100 (CN); Zhang, Huan, XI'AN, Shaanxi 710100 (CN); Liu, Yikun, XI'AN, Shaanxi 710100 (CN); Yang, Xiaoming, XI'AN, Shaanxi 710100 (CN); Chen, Shi, XI'AN, Shaanxi 710100 (CN); Dai, Xin, XI'AN, Shaanxi 710100 (CN); Yan, Yifei, XI'AN, Shaanxi 710100 (CN); Xu, Xinxing, XI'AN, Shaanxi 710100 (CN); Tong, Hongbo, XI'AN, Shaanxi 710100 (CN)
(74) Representative: Grünecker Patent- und Rechtsanwälte PartG mbB

(57) **Abstract**

The present application discloses a solar cell and a photovoltaic module, and relates to the field of photovoltaic technologies. To improve the working performance of the solar cell, the solar cell includes a semiconductor substrate, a first doped semiconductor portion, a first anti-reflection layer, and a second anti-reflection layer. The semiconductor substrate has a first surface and a second surface opposite to the first surface. The first surface has a first region and a second region that do not overlap with each other. A surface morphology of the first region is different from a surface morphology of the second region. The first doped semiconductor portion is arranged on the first region. The first anti-reflection layer is arranged on a surface of the first doped semiconductor portion facing away from the semiconductor substrate. The second anti-reflection layer is arranged on the second region. A difference between a surface reflectivity of a side of the first anti-reflection layer facing away from the semiconductor substrate and a surface reflectivity of a side of the second anti-reflection layer facing away from the semiconductor substrate is greater than or equal to 0.5% and less than or equal to 40%.

## Description

### TECHNICAL FIELD

The present application relates to the field of photovoltaic technologies, and in particular, to a solar cell and a photovoltaic module.

### BACKGROUND

At present, solar cells are increasingly widely used as a new energy alternative solution. A photovoltaic solar cell is an apparatus converting sun's light energy into electric energy. Specifically, in existing solar cells, film layers made of different materials may need to be arranged on different regions of a same surface of a semiconductor substrate. Surface morphologies of the different regions in the semiconductor substrate corresponding to the film layers made of different materials are usually different, which reflects different reflectivities, thereby improving quality of the film layers and improving a yield of the solar cells.

However, when the same surface is used as a light incident surface, the difference in reflectivities leads to imbalance between light trapping effects of two regions, and an anti-reflection layer arranged in the existing solar cells cannot meet light trapping requirements of regions having different surface morphologies, leading to poor working performance of the solar cells.

### SUMMARY

An objective of the present application is to provide a solar cell and a photovoltaic module, to resolve the problem that an anti-reflection layer arranged on regions having different surface morphologies in existing solar cells cannot meet light trapping requirements of the regions having different surface morphologies, thereby improving the working performance of the solar cell.

According to a first aspect, the present application provides a solar cell. The solar cell includes: a semiconductor substrate, a first doped semiconductor portion, a first anti-reflection layer, and a second anti-reflection layer. The semiconductor substrate has a first surface and a second surface opposite to the first surface. The first surface has a first region and a second region that do not overlap with each other. A surface morphology of the first region is different from a surface morphology of the second region. The first doped semiconductor portion is arranged on the first region. The first anti-reflection layer is arranged on a surface of the first doped semiconductor portion facing away from the semiconductor substrate. The second anti-reflection layer is arranged on the second region. A difference between a surface reflectivity of a side of the first anti-reflection layer facing away from the semiconductor substrate and a surface reflectivity of a side of the second anti-reflection layer facing away from the semiconductor substrate is greater than or equal to 0.5% and less than or equal to 40%.

**In** a case that the foregoing technical solution is used, it may be understood that, when the surface morphology of the first region is different from the surface morphology of the second region, a specific surface area of the first region may be different from a specific surface area of the second region, so that the first region and the second region having different specific surface areas on the first surface of the semiconductor substrate have different light trapping effects. In a case that other conditions are the same, when the light trapping effects of the surfaces of the regions are different, carrier concentrations in portions of the semiconductor substrate corresponding to the different surfaces of the regions may be unbalanced. In this case, the first anti-reflection layer and the second anti-reflection layer are respectively arranged on the first region and the second region having different surface morphologies. Viewing from the first surface of the solar cell, a difference between the surface reflectivity of the side of the first anti-reflection layer facing away from the semiconductor substrate and the surface reflectivity of the side of the second anti-reflection layer facing away from the semiconductor substrate may be reduced to be greater than or equal to 0.5% and less than or equal to 40%, to reduce a difference between light trapping effects of a surface of a side of the first anti-reflection layer facing away from the semiconductor substrate and a surface of a side of the second anti-reflection layer facing away from the semiconductor substrate, helping cause energy of light refracted from the first region and the second region into the semiconductor substrate to be approximately the same. Therefore, along a thickness direction of the semiconductor substrate, carrier concentrations in portions corresponding to the first region and the second region are relatively balanced when the solar cell is in a working state, so that a carrier difference generated between two regions is reduced while film layer quality on each region is ensured, thereby improving the working performance of the solar cell.

In a possible implementation, in a case that a surface of one of the first region and the second region is a polished surface and a surface of the other is a light trapping surface, the difference between the surface reflectivity of the side of the first anti-reflection layer facing away from the semiconductor substrate and the surface reflectivity of the side of the second anti-reflection layer facing away from the semiconductor substrate is greater than or equal to 15% and less than or equal to 40%. In this case, the difference between the light trapping effects of the surface on the side of the first anti-reflection layer facing away from the semiconductor substrate and the surface on the side of the second anti-reflection layer facing away from the semiconductor substrate that are respectively arranged on a polished surface and a light trapping surface having a great surface morphology difference may be reduced. Therefore, along the thickness direction of the semiconductor substrate, the carrier concentrations in the portions corresponding to the first region and the second region are relatively balanced when the solar cell is in the working state, so that a carrier recombination rate is reduced, thereby ensuring that the working performance of the solar cell can be improved.

In a possible implementation, in a case that surfaces of the first region and the second region are both light trapping surfaces and sizes of textured structures on the surfaces of the first region and the second region are different, the difference between the surface reflectivity of the side of the first anti-reflection layer facing away from the semiconductor substrate and the surface reflectivity of the side of the second anti-reflection layer facing away from the semiconductor substrate is greater than or equal to 0.5% and less than or equal to 3%. In this case, the difference between the light trapping effects of the surface on the side of the first anti-reflection layer facing away from the semiconductor substrate and the surface on the side of the second anti-reflection layer facing away from the semiconductor substrate may be further reduced, that are respectively arranged on light trapping surfaces having a small surface morphology difference. Therefore, along the thickness direction of the semiconductor substrate, the carrier concentrations in the portions corresponding to the first region and the second region are relatively balanced when the solar cell is in the working state, so that a carrier recombination rate is reduced, thereby ensuring that the working performance of the solar cell can be improved.

In a possible implementation, in a case that surfaces of the first region and the second region are both polished surfaces and sizes of tower base-shaped texture structures on the surfaces of the first region and the second region are different, the difference between the surface reflectivity of the side of the first anti-reflection layer facing away from the semiconductor substrate and the surface reflectivity of the side of the second anti-reflection layer facing away from the semiconductor substrate is greater than or equal to 0.5% and less than or equal to 3%. For beneficial effects in this case, reference may be made to the analysis of the beneficial effects when the difference between the surface reflectivity of the side of the first anti-reflection layer facing away from the semiconductor substrate and the surface reflectivity of the side of the second anti-reflection layer facing away from the semiconductor substrate is greater than or equal to 0.5% and less than or equal to 3% in the case that the surfaces of the first region and the second region are both light trapping surfaces and the sizes of textured structures on the surfaces of the first region and the second region are different described above. Details are not described herein.

In a possible implementation, the surface reflectivity of the side of the first anti-reflection layer facing away from the semiconductor substrate is greater than or equal to 1.5% and less than or equal to 3.5%.

In a case that the foregoing technical solution is used, the surface reflectivity of the side of the first anti-reflection layer facing away from the semiconductor substrate falls within the foregoing range, helping avoid a problem of small thicknesses and poor quality of the first doped semiconductor portion and the first anti-reflection layer formed on the first region, which is caused by a large specific surface area of the first region on the semiconductor substrate due to a small surface reflectivity of the side of the first anti-reflection layer facing away from the semiconductor substrate, thereby ensuring that the first doped semiconductor portion has a good field passivation effect on the semiconductor substrate and the first anti-reflection layer has a good chemical passivation effect on a side of the first doped semiconductor portion facing away from the semiconductor substrate. In addition, this also helps avoid a problem of excessively small energy of light refracted from the first anti-reflection layer into the first doped semiconductor portion and a portion of the semiconductor substrate corresponding to the first region, which is caused by a large surface reflectivity of the side of the first anti-reflection layer facing away from the semiconductor substrate, thereby ensuring that the first doped semiconductor portion and the portion of the semiconductor substrate corresponding to the first region have high light utilization.

In a possible implementation, the surface reflectivity of the side of the second anti-reflection layer facing away from the semiconductor substrate is greater than or equal to 1.2% and less than or equal to 3%.

In a case that the foregoing technical solution is used, the surface reflectivity of the side of the second anti-reflection layer facing away from the semiconductor substrate falls within the foregoing range, helping avoid a problem of a high light trapping requirement on the side of the second anti-reflection layer facing away from the semiconductor substrate of the solar cell in an actual application process caused by a small surface reflectivity of the side of the second anti-reflection layer facing away from the semiconductor substrate, and helping reduce the manufacturing difficulty of the solar cell. In addition, this also helps avoid a problem of a small increase degree of energy of light refracted from the second anti-reflection layer into a portion of the semiconductor substrate corresponding to the second region caused by a large surface reflectivity of the side of the second anti-reflection layer facing away from the semiconductor substrate, thereby ensuring that the portion of the semiconductor substrate corresponding to the second region has high light utilization.

In a possible implementation, a refractive index of the first anti-reflection layer is greater than a refractive index of the second anti-reflection layer. In this case, this helps further reduce a reflectivity difference between the first region and the second region, so that the first anti-reflection layer also has a good light trapping effect, thereby ensuring that the portion of the semiconductor substrate corresponding to the first region also has high light utilization.

In a possible implementation, a thickness of the first anti-reflection layer is greater than or equal to 40 nm and less than or equal to 160 nm.

In a case that the foregoing technical solution is used, the thickness of the first anti-reflection layer has a large optional range, helping select suitable values according to different actual application scenarios, and helping improve the applicability of the solar cell provided in the present application in different application scenarios. In addition, the thickness of the first anti-reflection layer falls within the foregoing range. It helps avoid a problem of a small improvement degree of the chemical passivation effect of the first anti-reflection layer on the side of the first doped semiconductor portion facing away from the semiconductor substrate caused by a small thickness of the first anti-reflection layer, thereby ensuring that the first anti-reflection layer has a good passivation effect. This also helps avoid a problem of large consumable usage of the first anti-reflection layer caused by a large thickness of the first anti-reflection layer, helping control costs.

In a possible implementation, the refractive index of the first anti-reflection layer is greater than or equal to 1.4 and less than or equal to 2.5.

In a case that the foregoing technical solution is used, the surface reflectivity of the side of the first anti-reflection layer facing away from the semiconductor substrate is greater than the surface reflectivity of the side of the second anti-reflection layer facing away from the semiconductor substrate. In this case, a refractive index of the side of the first anti-reflection layer facing away from the semiconductor substrate is greater than a refractive index of the side of the second anti-reflection layer facing away from the semiconductor substrate. Based on this, the refractive index of the first anti-reflection layer falls within the foregoing range. It helps avoid a problem of few light refracted from the first anti-reflection layer into the first doped semiconductor portion and the first region on the semiconductor substrate in an actual application process caused by a small refractive index of the first anti-reflection layer. In addition, this may also avoid a problem of a high light trapping requirement on the first anti-reflection layer caused a large refractive index of the first anti-reflection layer, helping reduce the manufacturing difficulty of the solar cell.

In a possible implementation, a thickness of the second anti-reflection layer is greater than or equal to 35 nm and less than or equal to 150 nm. Beneficial effects in this case are similar to the beneficial effects when the thickness of the first anti-reflection layer is greater than or equal to 40 nm and less than or equal to 160 nm described above, and details are not described herein.

In a possible implementation, the refractive index of the second anti-reflection layer is greater than or equal to 1.2 and less than or equal to 2.3. Beneficial effects in this case are similar to the beneficial effects when the refractive index of the first anti-reflection layer is greater than or equal to 1.4 and less than or equal to 2.5 described above, and details are not described herein.

In a possible implementation, a difference between a surface reflectivity of a side of the first doped semiconductor portion facing away from the semiconductor substrate and a surface reflectivity of the second region on the semiconductor substrate is greater than or equal to 3% and less than or equal to 8%.

In a case that the foregoing technical solution is used, the difference between the surface reflectivity of the side of the first doped semiconductor portion facing away from the semiconductor substrate and the surface reflectivity of the second region on the semiconductor substrate falls within the foregoing range. It helps avoid a problem of a small thickness and poor quality of the first doped semiconductor portion on the first region with a large specific surface area and/or a poor light trapping effect of the second region on the semiconductor substrate, which is caused by a small surface reflectivity of the side of the side of the first doped semiconductor portion facing away from the semiconductor substrate and/or a large surface reflectivity of the second region on the semiconductor substrate due to a small difference between the two surface reflectivities. In addition, this may also avoid a problem of a high risk that the formed first doped semiconductor portion is etched by an etching agent and/or an excessively high light trapping effect on the second region on the semiconductor substrate, which is caused by long time for adjusting a surface morphology of the second region on the semiconductor substrate resulted from an excessively large surface reflectivity of the side of the first doped semiconductor portion facing away from the semiconductor substrate and/or an excessively small surface reflectivity of the second region on the semiconductor substrate due to a large difference between the two surface reflectivities, helping reduce the manufacturing difficulty of the solar cell.

In a possible implementation, the surface reflectivity of the side of the first doped semiconductor portion facing away from the semiconductor substrate is greater than or equal to 5% and less than or equal to 10%. A range set for the surface reflectivity of the side of the first doped semiconductor portion facing away from the semiconductor substrate in this case is more proper, so that the problems described above caused by a large or small surface reflectivity of the side of the first doped semiconductor portion facing away from the semiconductor substrate may be avoided.

In a possible implementation, surface roughness of the first region on the first surface is less than surface roughness of the second region on the first surface. **In** this case, a surface of a region with larger surface roughness has a larger specific surface area and a better light trapping effect. Based on this, when the surface roughness of the first region on the first surface is smaller, the first doped semiconductor portion may be formed on the first region having a smaller specific surface area (that is, a flatter surface), helping increase a forming thickness of the first doped semiconductor portion and improve quality of the first doped semiconductor portion, thereby improving a field passivation effect of the first doped semiconductor portion on the semiconductor substrate. When the second region on the first surface has larger surface roughness, the second region has a better light trapping effect, helping improve light utilization of the semiconductor substrate.

In a possible implementation, a surface reflectivity of the first region on the first surface is greater than a surface reflectivity of the second region on the first surface. **In** this case, the second region on the first surface has a small surface reflectivity, so that more light can be refracted from the second region into the semiconductor substrate, helping improve light utilization of the semiconductor substrate. The first doped semiconductor portion is formed on the first region on the first surface, and a light-proof electrode generally needs to be arranged on the side of the first doped semiconductor portion facing away from the semiconductor substrate to lead out carriers collected by the electrode. Based on this, when the first region on the first surface has a large surface reflectivity, the first doped semiconductor portion may further be formed on a relatively flat surface while a light trapping requirement on the first region below the electrode is reduced, helping improve a thickness and quality of the first doped semiconductor portion.

In a possible implementation, the surface reflectivity of the first region on the first surface is greater than or equal to 10% and less than or equal to 15%. Beneficial effects in this case are similar to the beneficial effects when the surface reflectivity of the side of the first doped semiconductor portion facing away from the semiconductor substrate is greater than or equal to 5% and less than or equal to 10% described above, and details are not described herein.

In a possible implementation, the surface reflectivity of the second region on the first surface is greater than or equal to 7% and less than or equal to 10%. Beneficial effects in this case are similar to the beneficial effects when the surface reflectivity of the side of the second anti-reflection layer facing away from the semiconductor substrate is greater than or equal to 1.2% and less than or equal to 3% described above, and details are not described herein.

In a possible implementation, along a direction from the second surface to the first surface, the first region on the first surface is higher than the second region. In this case, compared with a case that surface heights of portions of the first surface are the same, when the first region on the first surface is higher than the second region, the first surface has a fluctuated morphology, so that a specific surface area of the first surface may be improved, and a light trapping effect of the first surface may be improved. In addition, a side wall at a junction between the first region and the second region can also reflect light, so that more light enters the semiconductor substrate from the second region.

In a possible implementation, along an arrangement direction of the first region and the second region, the second region includes a first sub-region and a second sub-region, where the first sub-region is located between the second sub-region and the first region, and the first sub-region is recessed toward the semiconductor substrate relative to the first region and the second sub-region respectively; and a texture structure is formed on the first sub-region. In this case, the first sub-region having the texture structure has a good light trapping effect, so that more light can be refracted from the first sub-region into the semiconductor substrate, thereby improving light utilization of the semiconductor substrate.

In a possible implementation, along the arrangement direction of the first region and the second region, a ratio of a width of the first sub-region to a width of the second sub-region is less than or equal to 0.3. In this case, this helps avoid a problem of bringing a greater challenge to a thin semiconductor substrate caused by an excessively large range of the first sub-region due to a large ratio.

In a possible implementation, a height difference between the first sub-region and the first region is greater than or equal to 1.5 µm and less than or equal to 5 µm. In this case, a problem of a requirement for a large semiconductor substrate subsequently to manufacture the solar cell caused by a large height difference between the first sub-region and the first region may be avoided, helping implement production of a thin solar cell. In addition, this may also avoid a poor light trapping effect of the first sub-region caused by a small height difference, thereby ensuring that the semiconductor substrate has high light utilization.

In a possible implementation, a height difference between the first sub-region and the second sub-region is greater than or equal to 1.5 µm and less than or equal to 3 µm. Beneficial effects in this case are similar to the beneficial effects when the height difference between the first sub-region and the first region is greater than or equal to 1.5 µm and less than or equal to 5 µm described above, and details are not described herein.

In a possible implementation, a pyramid-shaped texture structure is formed on both the first region and the second region, and a vertex angle of the pyramid-shaped texture structured formed on the first region is greater than a vertex angle of the pyramid-shaped texture structure formed on the second region. In this case, the pyramid-shaped texture structure formed on the first region with a large vertex angle has a smoother surface morphology, so that the first region has a small specific surface area, helping improve thicknesses and quality of the first doped semiconductor portion and a part of the first anti-reflection layer that are formed on the first region, thereby improving a passivation effect of the first doped semiconductor portion and the first anti-reflection layer on the first region. The pyramid-shaped texture structure formed on the second region with a small vertex angle has a sharper surface morphology, so that the second region has a large specific surface area, and the second region has a better light trapping effect.

In a possible implementation, a boundary between the first region and the second region is wave-shaped. In this case, the wave-shaped boundary has an uneven fluctuated morphology, helping further improve a light trapping effect of the boundary between the first region and the second region, thereby improving light utilization of the semiconductor substrate.

In a possible implementation, the solar cell further includes a second doped semiconductor portion, and a conductivity type of the second doped semiconductor portion is opposite to a conductivity type of the first doped semiconductor portion, where the second doped semiconductor portion is arranged on the second region, a material of the second doped semiconductor portion is different from a material of the first doped semiconductor portion, and the second anti-reflection layer is arranged on a side of the second doped semiconductor portion facing away from the semiconductor substrate; or the second doped semiconductor portion is arranged on or in the second surface.

In a case that the foregoing technical solution is used, when the second doped semiconductor portion is arranged on the second region, a light-shielding electrode structure may not need to be arranged on the second surface of the solar cell, so that more light can be refracted by the second surface into the semiconductor substrate, thereby improving light utilization of the solar cell. When the second doped semiconductor portion is arranged on or in the second surface, another example may be provided, improving the applicability of the solar cell provided in the present application in different application scenarios.

In a possible implementation, in a case that the second doped semiconductor portion is arranged on or in the second surface, a ratio of a surface reflectivity of a side of the second doped semiconductor portion facing away from the semiconductor substrate to a surface reflectivity of a side of the first doped semiconductor portion facing away from the semiconductor substrate is greater than or equal to 3 and less than or equal to 8. In this case, the surface reflectivity of the side of the first doped semiconductor portion facing away from the semiconductor substrate is lower, so that more light can be refracted through the first region into the semiconductor substrate, and the photoelectric conversion efficiency of the solar cell may be improved. The surface reflectivity of the second doped semiconductor portion arranged on the second surface is higher, helping reduce a light trapping requirement on the side of the second doped semiconductor portion facing away from the semiconductor substrate, thereby helping reduce the manufacturing difficulty of the solar cell.

In a possible implementation, in a case that the second doped semiconductor portion is arranged on or in the second surface, the surface reflectivity of the side of the second doped semiconductor portion facing away from the semiconductor substrate is greater than or equal to 30% and less than or equal to 40%. A range set for the surface reflectivity of the side of the second doped semiconductor portion facing away from the semiconductor substrate in this case is more proper, so that a problem of low light utilization of the second surface of the solar cell caused by a large surface reflectivity of the side of the second doped semiconductor portion facing away from the semiconductor substrate may be avoided.

In a possible implementation, in a case that the second doped semiconductor portion is arranged on or in the second surface, a reflectivity of the second surface is greater than or equal to 30% and less than or equal to 60%. Beneficial effects in this case are similar to the beneficial effects when the surface reflectivity of the side of the second doped semiconductor portion facing away from the semiconductor substrate is greater than or equal to 30% and less than or equal to 40% described above, and details are not described herein.

In a possible implementation, in a case that the second doped semiconductor portion is arranged on or in the second surface, the solar cell further includes a third anti-reflection layer formed on the second surface, where a surface reflectivity of the third anti-reflection layer is greater than or equal to 20% and less than or equal to 30%.

In a case that the foregoing technical solution is used, existence of the third anti-reflection layer may passivate the side of the second doped semiconductor portion facing away from the semiconductor substrate, to reduce a carrier recombination rate on the side. In addition, the surface reflectivity of the third anti-reflection layer falls within the foregoing range. It helps avoid a high light trapping requirement on the second surface of the solar cell in an actual application process caused by a small surface reflectivity of the third anti-reflection layer. In addition, this also helps avoid a problem of low energy of light refracted from the third anti-reflection layer into the semiconductor substrate caused by a large surface reflectivity of the third anti-reflection layer, thereby ensuring that the second surface of the semiconductor substrate has high light utilization.

In a possible implementation, a ratio of the surface reflectivity of the third anti-reflection layer to a surface reflectivity of the first anti-reflection layer is greater than or equal to 5. In this case, when the first surface corresponds to a front surface of the solar cell, the first anti-reflection layer has a small surface reflectivity, thereby ensuring that a light receiving surface of the solar cell has high light utilization. The surface reflectivity of the third anti-reflection layer arranged on a back surface of the solar cell is large, so that a light trapping requirement on the third anti-reflection layer may be reduced, thereby reducing the manufacturing difficulty of the solar cell.

In a possible implementation, in a case that the second doped semiconductor portion is arranged on or in the second surface, the first surface of the semiconductor substrate corresponds to a front surface of the solar cell.

In a possible implementation, in a case that the second doped semiconductor portion is arranged on or in the second surface, the solar cell further includes a first finger, where the first finger penetrates through a portion of the first anti-reflection layer corresponding to the first region and is in ohmic contact with the first doped semiconductor portion; and an orthographic projection of the first finger on the first surface is located in the first region.

In a case that the foregoing technical solution is used, the first finger penetrates through the first anti-reflection layer and is in ohmic contact with the first doped semiconductor portion; and the orthographic projection of the first finger on the first surface is located in the first region. In other words, the light-proof first finger is arranged on the first region having a greater surface reflectivity, so that an influence of the light-proof first finger on the second region having a better light trapping effect may be avoided, thereby ensuring that more light can be refracted through the side of the second anti-reflection layer having a smaller surface reflectivity facing away from the semiconductor substrate into the semiconductor substrate.

In a possible implementation, in a case that the solar cell includes the first finger, the solar cell further includes a first busbar formed on the first anti-reflection layer, where the first busbar is electrically connected to the first finger; and an orthographic projection of a partial region of the first busbar on the first surface is located in the second region. In this case, the orthographic projection of only a partial region of the light-proof first busbar on the first surface is located in the second region, thereby reducing an influence of a light shielding feature of the first busbar on light utilization of the semiconductor substrate.

In a possible implementation, the solar cell further includes a first interface passivation layer located between the first doped semiconductor portion and the semiconductor substrate.

In a possible implementation, when the second doped semiconductor portion is formed on the semiconductor substrate, the solar cell further includes a second interface passivation layer located between the second doped semiconductor portion and the semiconductor substrate.

In a possible implementation, in a case that the solar cell further includes the first interface passivation layer and the second interface passivation layer, a passivated contact type of a first passivation selective contact structure formed by the first interface passivation layer and the first doped semiconductor portion is different from a passivated contact type of a second passivation selective contact structure formed by the second interface passivation layer and the second doped semiconductor portion.

According to a second aspect, the present application provides a photovoltaic module. The photovoltaic module includes the solar cell according to the first aspect and various implementations of the first aspect.

In a possible implementation, in a case that the solar cell further includes the second doped semiconductor portion, a conductivity type of the second doped semiconductor portion is opposite to a conductivity type of the first doped semiconductor portion, and the second doped semiconductor portion is arranged on or in the second surface, the photovoltaic module includes an inter-string conductive member connecting two adjacent solar cells in series, where an orthographic projection of a partial region of the inter-string conductive member arranged on the first surface of the solar cell on the first surface is located in the second region.

For beneficial effects of the second aspect and various implementations of the second aspect in the present application, reference may be made to the analysis of the beneficial effects of the first aspect and various implementations of the first aspect, and details are not described herein.

### BRIEF DESCRIPTION OF THE DRAWINGS

The accompanying drawings described herein are used to provide a further understanding of the present application, and form a part of the present application. Exemplary embodiments of the present application and description thereof are used to explain the present application, and do not constitute any inappropriate limitation to the present application. In the accompanying drawings:
FIG. 1 is a schematic longitudinal cross-sectional view of a first structure of a solar cell according to an embodiment of the present application;
FIG. 2 is a schematic longitudinal cross-sectional view of a second structure of a solar cell according to an embodiment of the present application;
FIG. 3 is a longitudinal cross-sectional SEM view of a first surface of a semiconductor substrate at a junction between a first region and a second region according to an embodiment of the present application;
FIG. 4 is a top SEM view of a first surface of a semiconductor substrate at a junction between a first region and a second region according to an embodiment of the present application;
FIG. 5 is a schematic longitudinal cross-sectional view of a third structure of a solar cell according to an embodiment of the present application;
FIG. 6 is a schematic longitudinal cross-sectional view of a fourth structure of a solar cell according to an embodiment of the present application;
FIG. 7 is a schematic longitudinal cross-sectional view of a fifth structure of a solar cell according to an embodiment of the present application;
FIG. 8 is a schematic top view of a solar cell on a first surface according to an embodiment of the present application; and
FIG. 9 is another schematic top view of a solar cell on a first surface according to an embodiment of the present application.

Reference numerals: 11-Semiconductor substrate, 12-First surface, 13-Second surface, 14-First doped semiconductor portion, 15-First region, 16-Second region, 17-Second doped semiconductor portion, 18-First anti-reflection layer, 19-Second anti-reflection layer, 20-First interface passivation layer, 21-Second interface passivation layer, 22-First finger, 23-First busbar, 24-Second finger, and 25-Third anti-reflection layer.

### DETAILED DESCRIPTION

To make the technical problems to be resolved in the present application, the technical solutions, and beneficial effects more comprehensible, the following further describes the present application in detail with reference to the accompanying drawings and embodiments. It should be understood that, the specific embodiments described herein are merely used to explain the present application but are not intended to limit the present application.

It should be noted that, when an element is described as being "fixed to" or "arranged on" another element, the element may be directly located on the another element or indirectly located on the another element; and when an element is described as being "connected to" another element, the element may be directly connected to the another element or indirectly connected to the another element.

In addition, the terms "first" and "second" are used merely for the purpose of description, and shall not be construed as indicating or implying relative importance or implicitly indicating a quantity of indicated technical features. Therefore, a feature defined by "first" or "second" may explicitly indicate or implicitly include one or more features. In the description of the present application, unless otherwise explicitly specified, "a plurality of" means two or more than two; and unless otherwise explicitly specified, "several" means one or more than one.

In the description of the present application, it should be understood that orientation or position relationships indicated by the terms such as "on", "below", "front", "rear", "left", "right", and the like are based on orientation or position relationships shown in the accompanying drawings, and are used only for ease and brevity of illustration of the present application and description, rather than indicating or implying that the mentioned device or element must have a particular orientation or must be constructed and operated in a particular orientation. Therefore, such terms should not be construed as a limitation to the present application.

In the description of the present application, it should be noted that, unless otherwise explicitly specified or limited, the terms such as "mount", "connect", and "connection" should be understood in a broad sense. For example, the connection may be a fixed connection, a detachable connection, or an integral connection; or the connection may be a mechanical connection or an electrical connection; or the connection may be a direct connection, an indirect connection through an intermediary, internal communication between two elements, or an interactive relationship between two elements. A person of ordinary skill in the art can understand specific meanings of the terms in the present application according to specific situations.

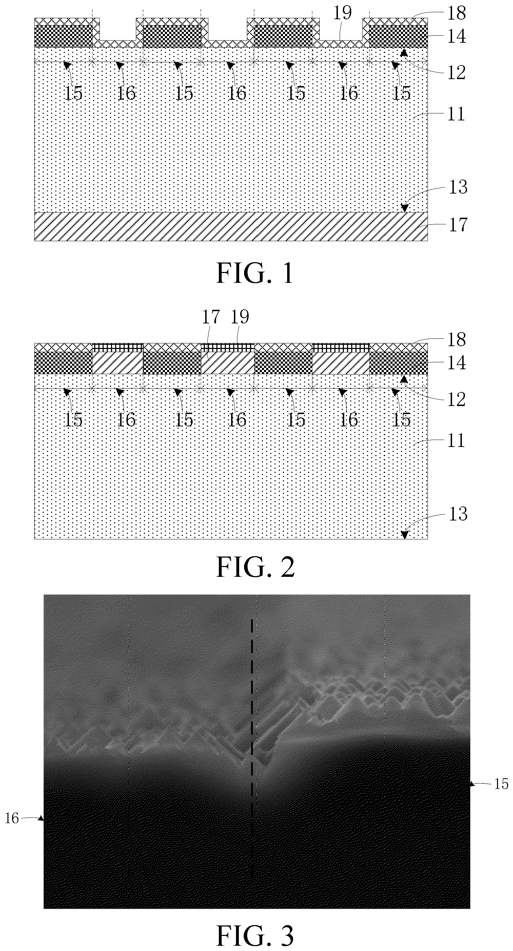

According to a first aspect, an embodiment of the present application provides a solar cell. As shown in FIG. 1 and FIG. 2, the solar cell provided in this embodiment of the present application includes: a semiconductor substrate 11, a first doped semiconductor portion 14, a first anti-reflection layer 18, and a second anti-reflection layer 19. The semiconductor substrate 11 has a first surface 12 and a second surface 13 opposite to the first surface. The first surface 12 has a first region 15 and a second region 16 that do not overlap with each other. The first doped semiconductor portion 14 is arranged on the first region 15. The first anti-reflection layer 18 is formed on a surface of the first doped semiconductor portion 14 facing away from the semiconductor substrate 11. The second anti-reflection layer 19 is arranged on the second region 16. A difference between a surface reflectivity of a side of the first anti-reflection layer 18 facing away from the semiconductor substrate 11 and a surface reflectivity of a side of the second anti-reflection layer 19 facing away from the semiconductor substrate 11 is greater than or equal to 0.5% and less than or equal to 4%.

In a case that the foregoing technical solution is used, as shown in FIG. 1 and FIG. 2, it may be understood that, when a surface morphology of the first region 15 is different from a surface morphology of the second region 16, a specific surface area of the first region 15 may be different from a specific surface area of the second region 16, so that the first region 15 and the second region 16 having different specific surface areas on the first surface 12 of the semiconductor substrate 11 have different light trapping effects. In a case that other conditions are the same, when the light trapping effects of the surfaces of the regions are different, carrier concentrations in portions of the semiconductor substrate 11 corresponding to the different surfaces of the regions may be unbalanced. In this case, the first anti-reflection layer 18 and the second anti-reflection layer 19 are respectively arranged on the first region 15 and the second region 16 having different surface morphologies. Viewing from the first surface 12 of the solar cell, a difference between the surface reflectivity of the side of the first anti-reflection layer 18 facing away from the semiconductor substrate 11 and the surface reflectivity of the side of the second anti-reflection layer 19 facing away from the semiconductor substrate 11 may be reduced to be greater than or equal to 0.5% and less than or equal to 40%, to reduce a difference between light trapping effects of a surface of a side of the first anti-reflection layer 18 facing away from the semiconductor substrate 11 and a surface of a side of the second anti-reflection layer 19 facing away from the semiconductor substrate 11, helping cause energy of light refracted from the first region 15 and the second region 16 into the semiconductor substrate 11 to be approximately the same. Therefore, along a thickness direction of the semiconductor substrate 11, carrier concentrations in portions corresponding to the first region 15 and the second region 16 are relatively balanced when the solar cell is in a working state, so that a carrier difference generated between two regions is reduced while film layer quality on each region is ensured, thereby improving the working performance of the solar cell.

Specifically, in an actual application process, the solar cell provided in this embodiment of the present application may be a double-sided contact solar cell or may be a back contact solar cell. As shown in FIG. 1 and FIG. 2, the solar cell may further include a second doped semiconductor portion 17, and a conductivity type of the second doped semiconductor portion 17 is opposite to a conductivity type of the first doped semiconductor portion 14. Specifically, when the solar cell provided in this embodiment of the present application is a back contact solar cell, the second doped semiconductor portion 17 is arranged on the second region 16, a material of the second doped semiconductor portion 17 is different from a material of the first doped semiconductor portion 14, and the second anti-reflection layer 19 is arranged on a side of the second doped semiconductor portion 17 facing away from the semiconductor substrate 11 in this case; or when the solar cell provided in this embodiment of the present application is a double-sided contact solar cell, the second doped semiconductor portion 17 is arranged on or in the second surface 13.

It should be noted that, when the solar cell provided in this embodiment of the present application is a double-sided solar cell and the conductivity type of the first doped semiconductor portion is opposite to a conductivity type of the semiconductor substrate, the solar cell may alternatively not include the second doped semiconductor portion.

For the semiconductor substrate, a material and the conductivity type of the semiconductor substrate are not specifically limited in the embodiments of the present application. For example, the material of the semiconductor substrate may include any one of semiconductor materials such as silicon, silicon germanium, or gallium arsenide. The semiconductor substrate may be a P-type semiconductor substrate, or may be an N-type semiconductor substrate, or may be an intrinsic semiconductor substrate.

For the first surface and the second surface opposite to the first surface included by the semiconductor substrate, when the solar cell provided in this embodiment of the present application is a double-sided contact solar cell, the first surface of the semiconductor substrate may correspond to a front surface of the solar cell, and the second surface of the semiconductor substrate corresponds to a back surface of the solar cell in this case; or the first surface of the semiconductor substrate may alternatively correspond to a back surface of the solar cell, and the second surface of the semiconductor substrate corresponds to a front surface of the solar cell in this case. When the solar cell provided in this embodiment of the present application is a back contact solar cell, the first surface of the semiconductor substrate corresponds to the back surface of the solar cell, and the second surface of the semiconductor substrate corresponds to the front surface of the solar cell.

Specifically, for the first surface of the semiconductor substrate, a distribution situation of the first region and the second region on the first surface may be determined according to a device type of the solar cell. For example, as shown in FIG. 1, in a case that the solar cell is a double-sided contact solar cell, the first doped semiconductor portion 14 included by the solar cell is formed on the first region 15 of the first surface 12. Based on this, it is defined that in the first surface 12, a region corresponding to the first doped semiconductor portion 14 is the first region 15, and a region not corresponding to the first doped semiconductor portion 14 is the second region 16. A boundary between the first region 15 and the second region 16 in the first surface 12 is a virtual boundary. A range of the first region 15 in the first surface 12 may be determined according to a formation range of the first doped semiconductor portion 14 in an actual application scenario, which is not specifically limited herein. For the second region 16, after the range of the first region 15 in the first surface 12 is determined, a range of the second region 16 in the first surface 12 is also determined.

For another example, as shown in FIG. 2, in a case that the solar cell is a back contact solar cell, the first doped semiconductor portion 14 included by the solar cell is arranged on the first region 15 of the first surface 12, and the second doped semiconductor portion 17 is arranged on the second region 16 of the first surface 12. Based on this, it is defined that in the first surface 12, a region corresponding to the first doped semiconductor portion 14 is the first region 15, and a region corresponding to the second doped semiconductor portion 17 is the second region 16. In this case, the first region 15 and the second region 16 may be adjacent to each other, or the first region 15 and the second region 16 may be spaced apart. A distribution situation of the first region 15 and the second region 16 may be set according to an actual requirement, which is not specifically limited herein.

In terms of surface morphologies, the surface morphologies of the first region and the second region are not specifically limited in the embodiments of the present application, provided that the surface morphologies of the two regions are different. That the surface morphologies of the first region and the second region are different may refer to that: a texture structure is arranged on a surface of one of the first region and the second region, and no texture structure is arranged on a surface of the other. Alternatively, that the surface morphologies of the first region and the second region are different may refer to that: texture structures of a same type are arranged on surfaces of the first region and the second region, and sizes of the texture structures on the surfaces of the first region and the second region are different. Alternatively, that the surface morphologies of the first region and the second region are different may refer to that: texture structures are arranged on surfaces of the first region and the second region, and types of the texture structures on the surfaces of the first region and the second region are different.

A type and a size of the texture structure are not specifically limited in the embodiments of the present application. For example, the texture structure may be a polished structure such as a tower base-shaped texture structure, or may be a textured structure such as a pyramid-shaped texture structure, a hole-type texture structure, or a V-shaped groove-type texture structure. Specific surface morphologies of the first region and the second region may be determined according to an actual requirement and the device type of the solar cell.

For example, a surface of one of the first region and the second region may be a polished surface, and a surface of the other may be a light trapping surface.

For example, surfaces of the first region and the second region may all be light trapping surfaces, and sizes of the textured structures on the surfaces of the first region and the second region are different.

For example, surfaces of the first region and the second region may all be polished surfaces, and sizes of tower base-shaped texture structures on the surfaces of the first region and the second region are different.

For example, as shown in FIG. 3, a pyramid-shaped texture structure is formed on both the first region 15 and the second region 16, and a vertex angle of the pyramid-shaped texture structured formed on the first region 15 is greater than a vertex angle of the pyramid-shaped texture structure formed on the second region 16. **In** this case, the pyramid-shaped texture structure formed on the first region 15 with a large vertex angle has a smoother surface morphology, so that the first region 15 has a small specific surface area, helping improve thicknesses and quality of the first doped semiconductor portion and a part of the first anti-reflection layer that are formed on the first region 15, thereby improving a passivation effect of the first doped semiconductor portion and the first anti-reflection layer on the first region 15. The pyramid-shaped texture structure formed on the second region 16 with a small vertex angle has a sharper surface morphology, so that the second region 16 has a large specific surface area, and the second region 16 has a better light trapping effect.

**In** an actual application process, surface roughness of the first region on the first surface may be less than or equal to surface roughness of the second region on the first surface. When the surface roughness of the first region on the first surface is less than the surface roughness of the second region on the first surface, the surface of the region with larger surface roughness has a larger specific surface area and a better light trapping effect. Based on this, when the surface roughness of the first region on the first surface is small, the first doped semiconductor portion may be formed on the first region having a smaller specific surface area (that is, a flatter surface), helping increase a thickness of the first doped semiconductor portion and improve quality of the first doped semiconductor portion, thereby improving a field passivation effect of the first doped semiconductor portion on the semiconductor substrate. When the second region on the first surface has larger surface roughness, the second region has a better light trapping effect, helping improve light utilization of the semiconductor substrate. Specifically, in this case, the surface roughness of the first region on the first surface may be less than the surface roughness of the second region on the first surface by adjusting morphologies and sizes of the texture structures formed on the first region and/or the second region.

For example, the first region is a surface on which no texture structure is formed, or a polished structure is formed on the first region. **In** addition, a textured structure such as a pyramid-shaped texture structure is formed on the second region, and the surface roughness of the first region on the first surface is less than the surface roughness of the second region on the first surface by adjusting sizes of the polished structures and the textured structures.

For another example, texture structures with a same morphology may be formed on the surfaces of the first region and the second region, and the surface roughness of the first region on the first surface is less than the surface roughness of the second region on the first surface by causing a size of the texture structure on the second region to be greater than a size of the texture structure on the first region.

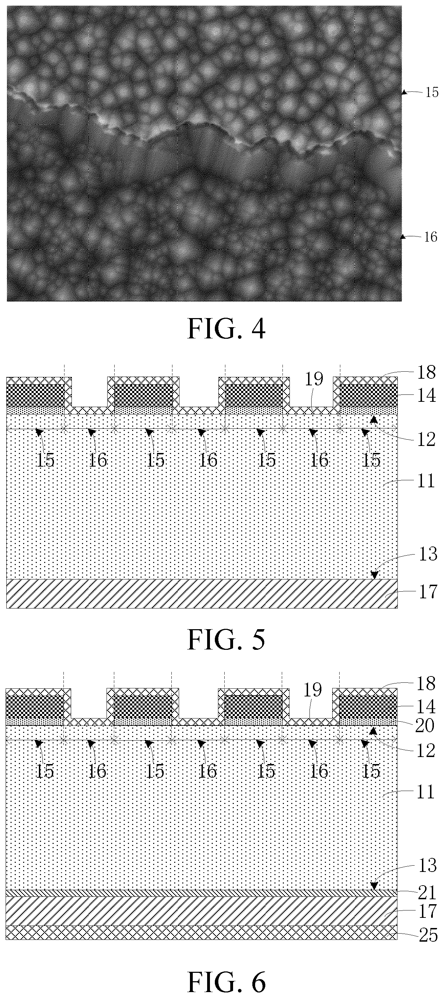

**In** terms of surface heights, heights of surfaces of regions of the first surface may be approximately the same. Alternatively, as shown in FIG. 3 and FIG. 4, along a direction from the second surface to the first surface, the first region 15 of the first surface may be higher than the second region 16. In this case, texturing treatment for a long time may be performed on a portion of the semiconductor substrate corresponding to the second region 16, to form a texture structure with a large size, thereby improving the light trapping effect of the second region 16. In addition, compared with a case that surface heights of portions of the first surface are the same, when the first region 15 of the first surface is higher than the second region 16, the first surface has a fluctuated morphology, so that a specific surface area of the first surface may be improved, and a light trapping effect of the first surface may be improved. In addition, a side wall at a junction between the first region 15 and the second region 16 can also reflect light, so that more light enters the semiconductor substrate from the second region 16.

Along an arrangement direction of the first region and the second region, heights of surfaces of regions of the second region may be approximately the same. Alternatively, as shown in FIG. 3, the second region 16 may include a first sub-region and a second sub-region. The first sub-region is located between the second sub-region and the first region 15, and the first sub-region is recessed toward the semiconductor substrate relative to the first region 15 and the second sub-region respectively; and a texture structure is formed on the first sub-region. In this case, the first sub-region having the texture structure has a good light trapping effect, so that more light can be refracted from the first sub-region into the semiconductor substrate, thereby improving light utilization of the semiconductor substrate.

A specific height difference between the first region and the second region, height differences between the first sub-region and the first region and the second sub-region respectively, and a ratio of a width of the first sub-region to a width of the second sub-region may be determined according to morphologies and sizes of texture structures formed on surfaces of the regions and an actual requirement, which are not specifically limited herein.

For example, a height difference between the first sub-region and the first region is greater than or equal to 1.5 µm and less than or equal to 5 µm. For example, the height difference between the first sub-region and the first region may be 1.5 µm, 1.8 µm, 2 µm, 3 µm, 4 µm, or 5 µm. In this case, a problem of a requirement for a large semiconductor substrate subsequently to manufacture the solar cell caused by a large height difference between the first sub-region and the first region may be avoided, helping implement production of a thin solar cell. In addition, this may also avoid a poor light trapping effect of the first sub-region caused by a small height difference, thereby ensuring that the semiconductor substrate has high light utilization.

For example, a height difference between the first sub-region and the second sub-region is greater than or equal to 1.5 µm and less than or equal to 3 µm. For example, the height difference between the first sub-region and the second sub-region may be 1.5 µm, 1.8 µm, 2 µm, 2.2 µm, 2.4 µm, 2.6 µm, or 3 µm. Beneficial effects in this case are similar to the beneficial effects when the height difference between the first sub-region and the first region is greater than or equal to 1.5 µm and less than or equal to 5 µm described above, and details are not described herein.

For example, along the arrangement direction of the first region and the second region, a ratio of a width of the first sub-region to a width of the second sub-region is less than or equal to 0.3. In this case, this helps avoid a problem of bringing a greater challenge to a thin semiconductor substrate caused by an excessively large range of the first sub-region due to a large ratio.

For a morphology of a boundary between the first region and the second region, the boundary is a linear boundary; or as shown in FIG. 4, the boundary may alternatively be a wave-shaped or broken line-shaped curved boundary. The wave-shaped or broken line-shaped curved boundary has an uneven fluctuated morphology, helping further improve a light trapping effect of the boundary between the first region 15 and the second region 16, thereby improving light utilization of the semiconductor substrate.

In terms of surface reflectivities, a surface reflectivity of the first region on the first surface may be greater than or equal to a surface reflectivity of the second region on the first surface, or a surface reflectivity of the first region on the first surface may alternatively be less than a surface reflectivity of the second region on the first surface. Specifically, values of the surface reflectivities of the first region and the second region may be determined according to the surface morphologies of the two regions and the device type of the solar cell. When the solar cell is a double-sided contact solar cell and the surface reflectivity of the first region is greater than the surface reflectivity of the second region, the second region on the first surface has a small surface reflectivity, so that more light can be refracted from the second region into the semiconductor substrate, helping improve light utilization of the semiconductor substrate. The first doped semiconductor portion is formed on the first region on the first surface, and a light-proof electrode generally needs to be arranged on the side of the first doped semiconductor portion facing away from the semiconductor substrate to lead out carriers collected by the electrode. Based on this, when the first region on the first surface has a large surface reflectivity, the first doped semiconductor portion may further be formed on a relatively flat surface while a light trapping requirement on the first region below the electrode is reduced, helping improve a thickness and quality of the first doped semiconductor portion. When the solar cell is a back contact solar cell and the surface reflectivity of the first region is greater than the surface reflectivity of the second region, the second region on the first surface has a small surface reflectivity. In this case, after the first doped semiconductor portion is formed and texturing treatment is performed on the second surface of the semiconductor substrate, a mask layer for protecting the second region may not need to be additionally formed, helping increase a direct contact area between the second doped semiconductor portion formed on the second region and a corresponding electrode while a manufacturing process of the solar cell is simplified, thereby reducing contact resistance.

Specific values of the surface reflectivities of the first region and the second region on the first surface may be set according to an actual application scenario, which are not specifically limited herein.

For example, the surface reflectivity of the first region on the first surface is greater than or equal to 10% and less than or equal to 15%. For example, the surface reflectivity of the first region on the first surface may be 10%, 11%, 12%, 13%, 14%, or 15%. In this case, the surface reflectivity of the first region on the first surface falls within the foregoing range, so that a problem of a small thickness and poor quality of the first doped semiconductor portion formed on the first region caused by a large specific surface area of the first region due to a small surface reflectivity of the first region on the first surface may be avoided, thereby ensuring that the first doped semiconductor portion has a good passivation effect on the semiconductor substrate. In addition, a problem of excessively low energy of light refracted through the second region into the semiconductor substrate caused by a large surface reflectivity of the first region on the first surface may also be avoided, thereby ensuring that a portion of the semiconductor substrate corresponding to the second region has high photoelectric conversion efficiency.

In a possible implementation, the surface reflectivity of the second region on the first surface is greater than or equal to 7% and less than or equal to 10%. For example, the surface reflectivity of the second region on the first surface may be 7%, 7.5%, 8%, 8.5%, 9%, 9.5%, or 10%. In this case, when the surface reflectivity of the second region on the first surface falls within the foregoing range, the surface reflectivity of the second region is small, so that more light can be refracted through the second region into the semiconductor substrate, thereby improving light utilization of the semiconductor substrate.

For the second surface of the semiconductor substrate, the second surface may be a surface on which no texture structure is formed. Alternatively, a texture structure may be formed on the second surface. In this case, a type and a size of the texture structure formed on the second surface are not specifically limited in the embodiments of the present application. The texture structure formed on the second surface may be a polished structure such as a tower base-shaped texture structure, or may be a textured structure such as a pyramid-shaped texture structure, a hole-type texture structure, or a V-shaped groove-type texture structure.

The reflectivity of the second surface may be determined according to the device type of the solar cell in an actual application scenario, which is not specifically limited herein.

For example, in a case that the solar cell is a double-sided contact solar cell, the second doped semiconductor portion is arranged on or in the second surface, and the reflectivity of the second surface is greater than or equal to 30% and less than or equal to 60%. For example, the reflectivity of the second surface may be 30%, 35%, 40%, 45%, 50%, 55%, or 60%. In this case, a problem of a small thickness and poor quality of the second doped semiconductor portion on the second surface caused by a large specific surface area of the second surface due to an excessively small reflectivity of the second surface may be avoided, thereby ensuring that the second doped semiconductor portion has a good field passivation effect on the semiconductor substrate.

For the first doped semiconductor portion, in terms of conductivity types, the first doped semiconductor portion may be an N-type doped semiconductor portion, and the second doped semiconductor portion is a P-type doped semiconductor portion in this case; or the first doped semiconductor portion may alternatively be a P-type doped semiconductor portion, and the second doped semiconductor portion is an N-type doped semiconductor portion in this case.

In terms of materials, a material of the first doped semiconductor portion may include a semiconductor material such as silicon, silicon germanium, germanium, or gallium arsenide. In terms of arrangement of substances, a crystalline phase of the first doped semiconductor portion may be an amorphous semiconductor portion, a microcrystalline semiconductor portion, a nanocrystalline semiconductor portion, a monocrystalline semiconductor portion, or a polycrystalline semiconductor portion.

In terms of forming positions, as shown in FIG. 1 and FIG. 2, the first doped semiconductor portion 14 may be directly formed on the first region 15 of the first surface 12. Alternatively, as shown in FIG. 5, the solar cell may further include a first interface passivation layer 20 located between the first doped semiconductor portion 14 and the semiconductor substrate 11. In this case, along a thickness direction of the semiconductor substrate 11, the first interface passivation layer 20 and the first doped semiconductor portion 14 are sequentially stacked on the first region 15. A material and a thickness of the first interface passivation layer 20 are not specifically limited in the embodiments of the present application, and may be set with reference to the material of the first doped semiconductor portion 14. For example, when the first doped semiconductor portion 14 includes a doped polysilicon layer, the first interface passivation layer 20 includes a tunneling passivation layer. For example, when the first doped semiconductor portion 14 includes a doped amorphous silicon layer, the first interface passivation layer 20 includes an intrinsic amorphous silicon layer.

In terms of surface reflectivities, a surface reflectivity of the side of the first doped semiconductor portion facing away from the semiconductor substrate is not specifically limited and may be determined according to the surface reflectivity of the first region on the first surface.

For example, a difference between the surface reflectivity of the side of the first doped semiconductor portion facing away from the semiconductor substrate and the surface reflectivity of the second region on the semiconductor substrate is greater than or equal to 3% and less than or equal to 8%. For example, the difference between the surface reflectivity of the side of the first doped semiconductor portion facing away from the semiconductor substrate and the surface reflectivity of the second region on the semiconductor substrate may be 3%, 4%, 5%, 6%, 7%, or 8%. In this case, the difference between the surface reflectivity of the side of the first doped semiconductor portion facing away from the semiconductor substrate and the surface reflectivity of the second region on the semiconductor substrate falls within the foregoing range. It helps avoid a problem of a small thickness and poor quality of the first doped semiconductor portion on the first region with a large specific surface area and/or a poor light trapping effect of the second region on the semiconductor substrate, which is caused by a small surface reflectivity of the side of the side of the first doped semiconductor portion facing away from the semiconductor substrate and/or a large surface reflectivity of the second region on the semiconductor substrate due to a small difference between the two surface reflectivities. In addition, this may also avoid a problem of a high risk that the formed first doped semiconductor portion is etched by an etching agent and/or an excessively high light trapping effect on the second region on the semiconductor substrate, which is caused by long time for adjusting a surface morphology of the second region on the semiconductor substrate resulted from an excessively large surface reflectivity of the side of the first doped semiconductor portion facing away from the semiconductor substrate and/or an excessively small surface reflectivity of the second region on the semiconductor substrate due to a large difference between the two surface reflectivities, helping reduce the manufacturing difficulty of the solar cell.

For example, the surface reflectivity of the side of the first doped semiconductor portion facing away from the semiconductor substrate is greater than or equal to 5% and less than or equal to 10%. For example, the surface reflectivity of the side of the first doped semiconductor portion facing away from the semiconductor substrate may be 5%, 6%, 7%, 8%, 9%, or 10%. A range set for the surface reflectivity of the side of the first doped semiconductor portion facing away from the semiconductor substrate in this case is more proper, so that the problems described above caused by a large or small surface reflectivity of the side of the first doped semiconductor portion facing away from the semiconductor substrate may be avoided.

For the first anti-reflection layer and the second anti-reflection layer, materials, thicknesses, and refractive indexes of the first anti-reflection layer and the second anti-reflection layer in the embodiments of the present application may be determined according to an actual application scenario, provided that the difference between the surface reflectivity of the side of the first anti-reflection layer facing away from the semiconductor substrate and the surface reflectivity of the side of the second anti-reflection layer facing away from the semiconductor substrate is greater than or equal to 0.5% and less than or equal to 40%.

At least one of the first anti-reflection layer and the second anti-reflection layer may include a passivation layer such as a stack layer of aluminum oxide and silicon nitride, or may be an anti-reflection layer with a conductive function such as a transparent conductive layer. The materials of the first anti-reflection layer and the second anti-reflection layer may be set according to an actual requirement. For example, the materials of the first anti-reflection layer and/or the second anti-reflection layer may include materials such as silicon oxide, silicon nitride, or aluminum oxide. The materials of the first anti-reflection layer and the second anti-reflection layer may be the same or may be different. The thickness of the first anti-reflection layer may be equal to the thickness of the second anti-reflection layer, or the thickness of the first anti-reflection layer may alternatively be greater than the thickness of the second anti-reflection layer. In addition, the refractive index of the first anti-reflection layer may be equal to the refractive index of the second anti-reflection layer, or the refractive index of the first anti-reflection layer may alternatively be greater than the refractive index of the second anti-reflection layer. When the refractive index of the first anti-reflection layer is greater than the refractive index of the second anti-reflection layer, this helps reduce a reflectivity difference between the first region and the second region, so that the first anti-reflection layer also has a good light trapping effect, thereby ensuring that the portion of the semiconductor substrate corresponding to the first region also has high light utilization.

For example, the thickness of the first anti-reflection layer is greater than or equal to 40 nm and less than or equal to 160 nm. For example, the thickness of the portion of the first anti-reflection layer corresponding to the first region may be 40 nm, 50 nm, 60 nm, 70 nm, 80 nm, 100 nm, 120 nm, 140 nm, or 160 nm. In this case, the thickness of the first anti-reflection layer has a large optional range, helping select suitable values according to different actual application scenarios, and helping improve the applicability of the solar cell provided in the embodiments of the present application in different application scenarios. In addition, the thickness of the first anti-reflection layer falls within the foregoing range. It helps avoid a problem of a small improvement degree of the chemical passivation effect of the first anti-reflection layer on the side of the first doped semiconductor portion facing away from the semiconductor substrate caused by a small thickness of the first anti-reflection layer, thereby ensuring that the first anti-reflection layer has a good passivation effect. This also helps avoid a problem of large consumable usage of the first anti-reflection layer caused by a large thickness of the first anti-reflection layer, helping control costs.

For example, the thickness of the second anti-reflection layer is greater than or equal to 35 nm and less than or equal to 150 nm. For example, the thickness of the portion of the first anti-reflection layer corresponding to the second region may be 35 nm, 40 nm, 50 nm, 70 nm, 90 nm, 110 nm, 130 nm, or 150 nm. Beneficial effects in this case are similar to the beneficial effects when the thickness of the first anti-reflection layer is greater than or equal to 40 nm and less than or equal to 160 nm described above, and details are not described herein.

For example, the refractive index of the first anti-reflection layer is greater than or equal to 1.4 and less than or equal to 2.5. For example, the refractive index of the first anti-reflection layer may be 1.4, 1.6, 1.8, 2, 2.2, 2.4, or 2.5. In this case, the surface reflectivity of the side of the first anti-reflection layer facing away from the semiconductor substrate is greater than the surface reflectivity of the side of the second anti-reflection layer facing away from the semiconductor substrate. In this case, a refractive index of the side of the first anti-reflection layer facing away from the semiconductor substrate is greater than a refractive index of the side of the second anti-reflection layer facing away from the semiconductor substrate. Based on this, the refractive index of the first anti-reflection layer falls within the foregoing range. It helps avoid a problem of few light refracted from the first anti-reflection layer into the first doped semiconductor portion and the first region on the semiconductor substrate in an actual application process, which is caused by a small refractive index of the first anti-reflection layer. In addition, this may also avoid a problem of a high light trapping requirement on the first anti-reflection layer caused a large refractive index of the first anti-reflection layer, helping reduce the manufacturing difficulty of the solar cell.

For example, the refractive index of the second anti-reflection layer is greater than or equal to 1.2 and less than or equal to 2.3. For example, the refractive index of the second anti-reflection layer is 1.2, 1.4, 1.6, 1.8, 2, 2.2, or 2.3. Beneficial effects in this case are similar to the beneficial effects when the refractive index of the first anti-reflection layer is greater than or equal to 1.4 and less than or equal to 2.5 described above, and details are not described herein.

In addition, in an actual application process, a specific value of the surface reflectivity of the side of the first anti-reflection layer facing away from the semiconductor substrate, a specific value of the surface reflectivity of the side of the second anti-reflection layer facing away from the semiconductor substrate, and a specific difference between the surface reflectivities of the two portions may be determined according to the surface morphologies of the first region and the second region in an actual application scenario, provided that the difference between the surface reflectivity of the side of the first anti-reflection layer facing away from the semiconductor substrate and the surface reflectivity of the side of the second anti-reflection layer facing away from the semiconductor substrate is greater than or equal to 0.5% and less than or equal to 40%. Specifically, the difference between the surface reflectivity of the side of the first anti-reflection layer facing away from the semiconductor substrate and the surface reflectivity of the side of the second anti-reflection layer facing away from the semiconductor substrate may be 0.5%, 0.8%, 1%, 1.2%, 1.5%, 1.8%, 2%, 2.4%, 2.8%, 3%, 5%, 10%, 15%, 20%, 25%, 30%, 35%, or 40%.

For example, in a case that the surface of one of the first region and the second region is a polished surface and the surface of the other is a light trapping surface, the difference between the surface reflectivity of the side of the first anti-reflection layer facing away from the semiconductor substrate and the surface reflectivity of the side of the side of the second anti-reflection layer facing away from the semiconductor substrate may be greater than or equal to 15% and less than or equal to 40%. For example, in this case, the difference between the surface reflectivity of the side of the first anti-reflection layer facing away from the semiconductor substrate and the surface reflectivity of the side of the second anti-reflection layer facing away from the semiconductor substrate may be 15%, 20%, 25%, 30%, 35%, or 40%. In this case, the difference between the light trapping effects of the surface on the side of the first anti-reflection layer facing away from the semiconductor substrate and the surface on the side of the second anti-reflection layer facing away from the semiconductor substrate that are respectively arranged on a polished surface and a light trapping surface having a great surface morphology difference may be reduced. Therefore, along the thickness direction of the semiconductor substrate, the carrier concentrations in the portions corresponding to the first region and the second region are relatively balanced when the solar cell is in the working state, so that a carrier recombination rate is reduced, thereby ensuring that the working performance of the solar cell can be improved.

For example, in a case that the surfaces of the first region and the second region are light trapping surfaces and the sizes of the textured structures on the surfaces of the first region and the second region are different, the difference between the surface reflectivity of the side of the first anti-reflection layer facing away from the semiconductor substrate and the surface reflectivity of the side of the second anti-reflection layer facing away from the semiconductor substrate may be greater than or equal to 0.5% and less than or equal to 3%. For example, in this case, the difference between the surface reflectivity of the side of the first anti-reflection layer facing away from the semiconductor substrate and the surface reflectivity of the side of the second anti-reflection layer facing away from the semiconductor substrate may be 0.5%, 0.8%, 1%, 1.2%, 1.5%, 1.8%, 2%, 2.4%, 2.8%, or 3%. In this case, the difference between the light trapping effects of the surface on the side of the first anti-reflection layer facing away from the semiconductor substrate and the surface on the side of the second anti-reflection layer facing away from the semiconductor substrate may be further reduced, that are respectively arranged on light trapping surfaces having a small surface morphology difference. Therefore, along the thickness direction of the semiconductor substrate, the carrier concentrations in the portions corresponding to the first region and the second region are relatively balanced when the solar cell is in the working state, so that a carrier recombination rate is reduced, thereby ensuring that the working performance of the solar cell can be improved.

For example, in a case that the surfaces of the first region and the second region are polished surfaces and the sizes of the tower base-shaped texture structures on the surfaces of the first region and the second region are different, the difference between the surface reflectivity of the side of the first anti-reflection layer facing away from the semiconductor substrate and the surface reflectivity of the side of the second anti-reflection layer facing away from the semiconductor substrate is greater than or equal to 0.5% and less than or equal to 3%. For example, in this case, the difference between the surface reflectivity of the side of the first anti-reflection layer facing away from the semiconductor substrate and the surface reflectivity of the side of the second anti-reflection layer facing away from the semiconductor substrate may be 0.5%, 0.8%, 1%, 1.2%, 1.5%, 1.8%, 2%, 2.4%, 2.8%, or 3%. For beneficial effects in this case, reference may be made to the analysis of the beneficial effects when the difference between the surface reflectivity of the side of the first anti-reflection layer facing away from the semiconductor substrate and the surface reflectivity of the side of the second anti-reflection layer facing away from the semiconductor substrate is greater than or equal to 0.5% and less than or equal to 3% in the case that the surfaces of the first region and the second region are both light trapping surfaces and the sizes of textured structures on the surfaces of the first region and the second region are different described above. Details are not described herein.

For example, the surface reflectivity of the side of the first anti-reflection layer facing away from the semiconductor substrate is greater than or equal to 1.5% and less than or equal to 3.5%. For example, the surface reflectivity of the side of the first anti-reflection layer facing away from the semiconductor substrate may be 1.5%, 1.8%, 2%, 2.2%, 2.5%, 2.8%, 3%, 3.2%, or 3.5%. **In** this case, the surface reflectivity of the side of the first anti-reflection layer facing away from the semiconductor substrate falls within the foregoing range. It helps avoid a problem of small thicknesses and poor quality of the first doped semiconductor portion and the first anti-reflection layer formed on the first region, which is caused by a large specific surface area of the first region on the semiconductor substrate due to a small surface reflectivity of the side of the first anti-reflection layer facing away from the semiconductor substrate, thereby ensuring that the first doped semiconductor portion has a good field passivation effect on the semiconductor substrate and the first anti-reflection layer has a good chemical passivation effect on a side of the first doped semiconductor portion facing away from the semiconductor substrate. **In** addition, this also helps avoid a problem of excessively small energy of light refracted from the first anti-reflection layer into the first doped semiconductor portion and a portion of the semiconductor substrate corresponding to the first region, which is caused by a large surface reflectivity of the side of the first anti-reflection layer facing away from the semiconductor substrate, thereby ensuring that the first doped semiconductor portion and the portion of the semiconductor substrate corresponding to the first region have high light utilization.

For example, the surface reflectivity of the side of the second anti-reflection layer facing away from the semiconductor substrate is greater than or equal to 1.2% and less than or equal to 3%. For example, the surface reflectivity of the side of the second anti-reflection layer facing away from the semiconductor substrate may be 1.2%, 1.5%, 1.8%, 2%, 2.2%, 2.5%, 2.8%, or 3%. In this case, the surface reflectivity of the side of the second anti-reflection layer facing away from the semiconductor substrate falls within the foregoing range. It helps avoid a problem of a high light trapping requirement on the side of the second anti-reflection layer facing away from the semiconductor substrate of the solar cell in an actual application process caused by a small surface reflectivity of the side of the second anti-reflection layer facing away from the semiconductor substrate, and helping reduce the manufacturing difficulty of the solar cell. In addition, this also helps avoid a problem of a small increase degree of energy of light refracted from the second anti-reflection layer into a portion of the semiconductor substrate corresponding to the second region caused by a large surface reflectivity of the side of the second anti-reflection layer facing away from the semiconductor substrate, thereby ensuring that the portion of the semiconductor substrate corresponding to the second region has high light utilization.

It should be noted that, the first anti-reflection layer and the second anti-reflection layer may be an integrally arranged structure. In this case, the materials of the first anti-reflection layer and the second anti-reflection layer are the same, but since the surface morphologies of the first region and the second region are different, surface morphologies and thicknesses of the first anti-reflection layer and the second anti-reflection layer respectively formed on the first region and the second region may be different, and the first anti-reflection layer and the second anti-reflection layer have different refractive indexes.

For the second doped semiconductor portion, in terms of forming positions, in a case that the solar cell is a double-sided contact solar cell, the second doped semiconductor portion may be formed in the second surface, and the second doped semiconductor portion is a doped region formed in the semiconductor substrate in this case; or the second doped semiconductor portion may alternatively be formed on the second surface, and the second doped semiconductor portion is a doped layer formed on the semiconductor substrate. In a case that the solar cell is a back contact solar cell, the second doped semiconductor portion is a doped layer arranged on the second region.

When the second doped semiconductor portion is arranged on the semiconductor substrate, a material of the second doped semiconductor portion may include a semiconductor material such as silicon, silicon germanium, germanium, or gallium arsenide. In terms of arrangement of substances, a crystalline phase of the second doped semiconductor portion may be an amorphous semiconductor portion, a microcrystalline semiconductor portion, a nanocrystalline semiconductor portion, a monocrystalline semiconductor portion, or a polycrystalline semiconductor portion. It should be noted that, when the solar cell is a back contact solar cell, the material of the second doped semiconductor portion needs to be different from the material of the first doped semiconductor portion. In this case, that the material of the second doped semiconductor portion is different from the material of the first doped semiconductor portion may refer to that: at least one of types of the materials, substance arrangement manners of the materials, and doping elements in the materials of the first doped semiconductor portion and the second doped semiconductor portion are different. The materials of the first doped semiconductor portion and the second doped semiconductor portion may be set according to an actual requirement, which are not specifically limited herein. For example, the material of the first doped semiconductor portion may include a doped polysilicon layer, and the material of the second doped semiconductor portion may include doped amorphous silicon.

In addition, when the second doped semiconductor portion is arranged on the semiconductor substrate, as shown in FIG. 5, the second doped semiconductor portion 17 may be directly formed on the second surface 13. Alternatively, as shown in FIG. 6, the solar cell may further include a second interface passivation layer 21 located between the second doped semiconductor portion 17 and the semiconductor substrate 11. A material and a thickness of the second interface passivation layer 21 are not specifically limited in the embodiments of the present application, and may be determined according to the material of the second doped semiconductor portion 17.

It should be noted that, in a case that the solar cell is a double-sided solar cell and the solar cell further includes the first interface passivation layer and the second interface passivation layer, a passivated contact type of a first passivation selective contact structure formed by the first interface passivation layer and the first doped semiconductor portion may be the same as or different from a passivated contact type of a second passivation selective contact structure formed by the second interface passivation layer and the second doped semiconductor portion. For example, in a case that the solar cell is a double-sided contact solar cell, both the first passivation selective contact structure and the second passivation selective contact structure may be tunneling passivation contact structures or heterogeneous contact structures. For another example, in a case that the solar cell is a double-sided contact solar cell, one of the first passivation selective contact structure and the second passivation selective contact structure may be a tunneling passivation contact structure, and the other is a heterogeneous contact structure.

In a case that the solar cell is a back contact solar cell, the passivated contact type of the first passivation selective contact structure is different from the passivated contact type of the second passivation selective contact structure. For example, in a case that the solar cell is a back contact solar cell, one of the first passivation selective contact structure and the second passivation selective contact structure may be a tunneling passivation contact structure, and the other is a heterogeneous contact structure.

In terms of surface reflectivities, a surface reflectivity of the side of the second doped semiconductor portion facing away from the semiconductor substrate may be determined according to the device type of the solar cell, which is not specifically limited herein, provided that the surface reflectivity can be applied to the embodiments of the present application.

For example, in a case that the second doped semiconductor portion is arranged on or in the second surface, the surface reflectivity of the side of the second doped semiconductor portion facing away from the semiconductor substrate is greater than or equal to 30% and less than or equal to 40%. For example, the surface reflectivity of the side of the second doped semiconductor portion facing away from the semiconductor substrate may be 30%, 31%, 32%, 33%, 34%, 35%, 36%, 37%, 38%, 39%, or 40%. A range set for the surface reflectivity of the side of the second doped semiconductor portion facing away from the semiconductor substrate in this case is more proper, so that a problem of low light utilization of the second surface of the solar cell caused by a large surface reflectivity of the side of the second doped semiconductor portion facing away from the semiconductor substrate may be avoided.

For example, in a case that the second doped semiconductor portion is arranged on or in the second surface, a ratio of the surface reflectivity of the side of the second doped semiconductor portion facing away from the semiconductor substrate to the surface reflectivity of the side of the first doped semiconductor portion facing away from the semiconductor substrate is greater than or equal to 3 and less than or equal to 8. For example, the ratio of the surface reflectivity of the side of the second doped semiconductor portion facing away from the semiconductor substrate to the surface reflectivity of the side of the first doped semiconductor portion facing away from the semiconductor substrate may be 3, 4, 5, 6, 7, or 8. In this case, the surface reflectivity of the side of the first doped semiconductor portion facing away from the semiconductor substrate is lower, so that more light can be refracted through the first region into the semiconductor substrate, and the photoelectric conversion efficiency of the solar cell may be improved. The surface reflectivity of the second doped semiconductor portion arranged on the second surface is higher, helping reduce a light trapping requirement on the side of the second doped semiconductor portion facing away from the semiconductor substrate, thereby helping reduce the manufacturing difficulty of the solar cell.

In an actual application process, as shown in FIG. 6, in a case that the second doped semiconductor portion 17 is arranged on or in the second surface 13, the solar cell further includes a third anti-reflection layer 25 formed on the second surface 13, to passivate the side of the second doped semiconductor portion facing away from the semiconductor substrate 11. A material, a thickness, and a surface reflectivity of the third anti-reflection layer 25 are not specifically limited in the embodiments of the present application.

For example, the surface reflectivity of the third anti-reflection layer may be greater than or equal to 20% and less than or equal to 30%. For example, the surface reflectivity of the third anti-reflection layer may be 20%, 21%, 22%, 23%, 24%, 25%, 26%, 27%, or 30%. In this case, existence of the third anti-reflection layer may passivate the side of the second doped semiconductor portion facing away from the semiconductor substrate, to reduce a carrier recombination rate on the side. In addition, the surface reflectivity of the second anti-reflection layer falls within the foregoing range. It helps avoid a high light trapping requirement on the second surface of the solar cell in an actual application process caused by a small surface reflectivity of the second anti-reflection layer. In addition, this also helps avoid a problem of low energy of light refracted from the second anti-reflection layer into the semiconductor substrate caused by a large surface reflectivity of the second anti-reflection layer, thereby ensuring that the second surface of the semiconductor substrate has high light utilization.

The surface reflectivity of the third anti-reflection layer may be equal to the surface reflectivity of the first anti-reflection layer; or the surface reflectivity of the third anti-reflection layer may alternatively be greater than the surface reflectivity of the first anti-reflection layer. In this case, a difference or a ratio between the surface reflectivity of the third anti-reflection layer and the surface reflectivity of the first anti-reflection layer may be determined according to an actual application scenario.

For example, the ratio of the surface reflectivity of the third anti-reflection layer to the surface reflectivity of the first anti-reflection layer is greater than or equal to 5. For example, the ratio of the surface reflectivity of the third anti-reflection layer to the surface reflectivity of the first anti-reflection layer may be 5, 6, 7, 8, or 9. In this case, when the first surface corresponds to a front surface of the solar cell, the first anti-reflection layer has a small surface reflectivity, thereby ensuring that a light receiving surface of the solar cell has high light utilization. The surface reflectivity of the third anti-reflection layer arranged on a back surface of the solar cell is large, so that a light trapping requirement on the third anti-reflection layer may be reduced, thereby reducing the manufacturing difficulty of the solar cell.

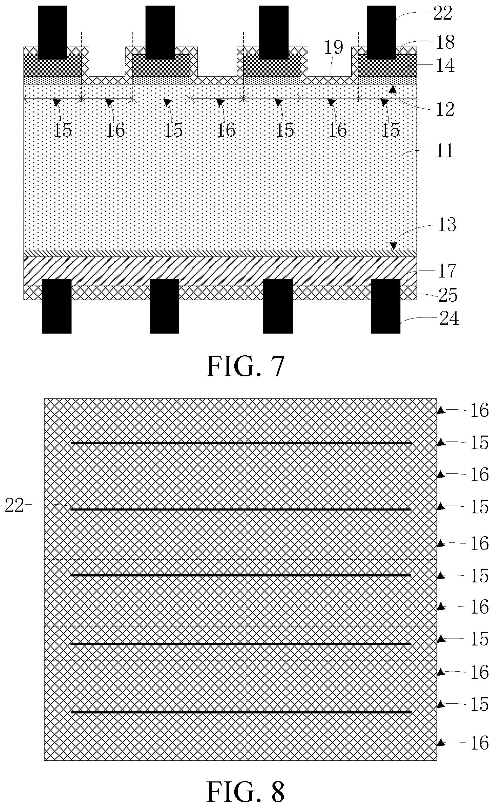

In addition, in an actual application process, as shown in FIG. 7 and FIG. 8, in a case that the second doped semiconductor portion 17 is arranged on or in the second surface 13, the solar cell further includes a first finger 22, where the first finger 22 penetrates through a portion of the first anti-reflection layer 18 corresponding to the first region 15 and is in ohmic contact with the first doped semiconductor portion 14; and an orthographic projection of the first finger 22 on the first surface 12 is located in the first region 15. In this case, the first finger 22 penetrates through the first anti-reflection layer 18 and is in ohmic contact with the first doped semiconductor portion 14; and the orthographic projection of the first finger 22 on the first surface 12 is located in the first region 15. In other words, the light-proof first finger 22 is arranged on the first region 15 having a greater surface reflectivity, so that an influence of the light-proof first finger 22 on the second region 16 having a better light trapping effect may be avoided, thereby ensuring that more light can be refracted through the side of the second anti-reflection layer 19 having a smaller surface reflectivity facing away from the semiconductor substrate 11 into the semiconductor substrate 11. A material of the first finger 22 and a coverage range of the first finger 22 on the first doped semiconductor portion 14 are not specifically limited in the embodiments of the present application.

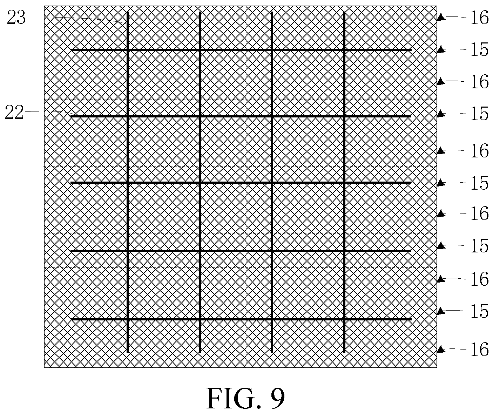

As shown in FIG. 9, in a case that the solar cell includes the first finger 22, the solar cell further includes a first busbar 23 formed on the first anti-reflection layer 18, where the first busbar 23 is electrically connected to the first finger 22; and an orthographic projection of a partial region of the first busbar 23 on the first surface 12 is located in the second region 16. In this case, the orthographic projection of only a partial region of the light-proof first busbar 23 on the first surface 12 is located in the second region 16, thereby reducing an influence of a light shielding feature of the first busbar 23 on light utilization of the semiconductor substrate 11.

The solar cell may alternatively not include the first busbar. In this case, carriers collected by different first fingers may be gathered through an inter-string conductive member such as a welding strip.

In addition, as shown in FIG. 7, in a case that the second doped semiconductor portion 17 is arranged on or in the second surface 13, an embodiment of the present application may further include a second finger 24 located on the side of the second doped semiconductor portion 17 facing away from the semiconductor substrate 11, to collect carriers in the second doped semiconductor portion 17.

In a case that the solar cell includes the second finger, the solar cell may further include a second busbar formed on the second doped semiconductor portion, where the second busbar is electrically connected to the second finger. Certainly, the solar cell may alternatively not include the second busbar. In this case, carriers collected by different second fingers may be gathered through an inter-string conductive member such as a welding strip.

Alternatively, the solar cell may not include structures such as the first finger, the second finger, the first busbar, and the second busbar. In this case, when the solar cell is used in a photovoltaic module, carriers in the first doped semiconductor portion and the second doped semiconductor portion may be collected and led out by using an electrode grid. In this case, an orthographic projection of the electrode grid arranged on the first surface on the first surface is at least partially located in the first region.

When the solar cell provided in the embodiments of the present application is a back contact solar cell, an embodiment of the present application may further include a first finger arranged on the side of the first doped semiconductor portion facing away from the semiconductor substrate and a second finger arranged on the side of the second doped semiconductor portion facing away from the semiconductor substrate. For materials of the first finger and the second finger, reference may be made to the foregoing description. In addition, in this case, the solar cell may further include a first busbar arranged on the side of the first doped semiconductor portion facing away from the semiconductor substrate and electrically connected to the first finger and a second busbar arranged on the side of the second doped semiconductor portion facing away from the semiconductor substrate and electrically connected to the second finger.

Alternatively, when the solar cell provided in the embodiments of the present application is a back contact solar cell, the solar cell may alternatively not include structures such as the first finger, the second finger, the first busbar, and the second busbar. In this case, when the solar cell is used in a photovoltaic module, carriers in the first doped semiconductor portion and the second doped semiconductor portion may be collected and led out by using an electrode grid.

According to a second aspect, an embodiment of the present application provides a photovoltaic module. The photovoltaic module includes the solar cell according to the first aspect and various implementations of the first aspect.

For example, in a case that the solar cell further includes the second doped semiconductor portion, a conductivity type of the second doped semiconductor portion is opposite to a conductivity type of the first doped semiconductor portion, and the second doped semiconductor portion is arranged on or in the second surface, the photovoltaic module includes an inter-string conductive member connecting two adjacent solar cells in series, where an orthographic projection of a partial region of the inter-string conductive member arranged on the first surface of the solar cell on the first surface is located in the second region. The first doped semiconductor portion is not arranged around the inter-string conductive member, so that a region around the inter-string conductive member may have a small reflectivity, thereby improving a light trapping effect and improving module power.

For beneficial effects of the second aspect and various implementations of the second aspect in the embodiments of the present application, reference may be made to the analysis of the beneficial effects of the first aspect and various implementations of the first aspect, and details are not described herein.

The foregoing description is merely specific implementations of the present application, but is not intended to limit the protection scope of the present application. Any variation or replacement readily figured out by a person skilled in the art within the technical scope disclosed in the present application shall fall within the protection scope of the present application. Therefore, the protection scope of the present application shall be subject to the protection scope of the claims.

## Claims

1. A solar cell, comprising:
a semiconductor substrate (11), having a first surface (12) and a second surface (13) opposite to the first surface (12), wherein the first surface (12) has a first region (15) and a second region (16) that do not overlap with each other; and a surface morphology of the first region (15) is different from a surface morphology of the second region (16);
a first doped semiconductor portion (14), arranged on the first region (15);
a first anti-reflection layer (18), formed on a surface of the first doped semiconductor portion (14) facing away from the semiconductor substrate (11); and
a second anti-reflection layer (19), arranged on the second region (16), wherein a difference between a surface reflectivity of a side of the first anti-reflection layer (18) facing away from the semiconductor substrate (11) and a surface reflectivity of a side of the second anti-reflection layer (19) facing away from the semiconductor substrate (11) is greater than or equal to 0.5% and less than or equal to 40%.

2. The solar cell according to claim 1, wherein in a case that a surface of one of the first region (15) and the second region (16) is a polished surface and a surface of the other is a light trapping surface, the difference between the surface reflectivity of the side of the first anti-reflection layer (18) facing away from the semiconductor substrate (11) and the surface reflectivity of the side of the second anti-reflection layer (19) facing away from the semiconductor substrate (11) is greater than or equal to 15% and less than or equal to 40%; or
in a case that surfaces of the first region (15) and the second region (16) are both light trapping surfaces and sizes of textured structures on the surfaces of the first region (15) and the second region (16) are different, the difference between the surface reflectivity of the side of the first anti-reflection layer (18) facing away from the semiconductor substrate (11) and the surface reflectivity of the side of the second anti-reflection layer (19) facing away from the semiconductor substrate (11) is greater than or equal to 0.5% and less than or equal to 3%; or
in a case that surfaces of the first region (15) and the second region (16) are both polished surfaces and sizes of tower base-shaped texture structures on the surfaces of the first region (15) and the second region (16) are different, the difference between the surface reflectivity of the side of the first anti-reflection layer (18) facing away from the semiconductor substrate (11) and the surface reflectivity of the side of the second anti-reflection layer (19) facing away from the semiconductor substrate (11) is greater than or equal to 0.5% and less than or equal to 3%.

3. The solar cell according to claim 1, wherein a refractive index of the first anti-reflection layer (18) is greater than a refractive index of the second anti-reflection layer (19).

4. The solar cell according to claim 1, wherein a difference between a surface reflectivity of a side of the first doped semiconductor portion (14) facing away from the semiconductor substrate (11) and a surface reflectivity of the second region (16) on the semiconductor substrate (11) is greater than or equal to 3% and less than or equal to 8%; and/or
the surface reflectivity of the side of the first doped semiconductor portion (14) facing away from the semiconductor substrate (11) is greater than or equal to 5% and less than or equal to 10%.

5. The solar cell according to claim 1, wherein surface roughness of the first region (15) on the first surface (12) is less than surface roughness of the second region (16) on the first surface (12); and/or
a surface reflectivity of the first region (15) on the first surface (12) is greater than a surface reflectivity of the second region (16) on the first surface (12); and/or
the surface reflectivity of the first region (15) on the first surface (12) is greater than or equal to 10% and less than or equal to 15%; and/or
the surface reflectivity of the second region (16) on the first surface (12) is greater than or equal to 7% and less than or equal to 10%.

6. The solar cell according to claim 1, wherein along a direction from the second surface (13) to the first surface (12), the first region (15) on the first surface (12) is higher than the second region (16).

7. The solar cell according to claim 1, wherein along an arrangement direction of the first region (15) and the second region (16), the second region (16) comprises a first sub-region and a second sub-region, wherein the first sub-region is located between the second sub-region and the first region (15), and the first sub-region is recessed toward the semiconductor substrate (11) relative to the first region (15) and the second sub-region respectively; and a texture structure is formed on the first sub-region; and
wherein along the arrangement direction of the first region (15) and the second region (16), a ratio of a width of the first sub-region to a width of the second sub-region is less than or equal to 0.3; and/or
a height difference between the first sub-region and the first region (15) is greater than or equal to 1.5 µm and less than or equal to 5 µm; and/or
a height difference between the first sub-region and the second sub-region is greater than or equal to 1.5 µm and less than or equal to 3 µm.

8. The solar cell according to claim 1, wherein a pyramid-shaped texture structure is formed on both the first region (15) and the second region (16), and a vertex angle of the pyramid-shaped texture structure formed on the first region (15) is greater than a vertex angle of the pyramid-shaped texture structure formed on the second region (16).

9. The solar cell according to claim 1, wherein a boundary between the first region (15) and the second region (16) is wave-shaped.

10. The solar cell according to claim 1, wherein the solar cell further comprises a second doped semiconductor portion (17), and a conductivity type of the second doped semiconductor portion (17) is opposite to a conductivity type of the first doped semiconductor portion (14), wherein
the second doped semiconductor portion (17) is arranged on the second region (16), a material of the second doped semiconductor portion (17) is different from a material of the first doped semiconductor portion (14), and the second anti-reflection layer (19) is arranged on a side of the second doped semiconductor portion (17) facing away from the semiconductor substrate (11); or
the second doped semiconductor portion (17) is arranged on or in the second surface (13); and , wherein in a case that the second doped semiconductor portion (17) is arranged on or in the second surface (13),
a ratio of a surface reflectivity of a side of the second doped semiconductor portion (17) facing away from the semiconductor substrate (11) to a surface reflectivity of a side of the first doped semiconductor portion (14) facing away from the semiconductor substrate (11) is greater than or equal to 3 and less than or equal to 8; and/or
the surface reflectivity of the side of the second doped semiconductor portion (17) facing away from the semiconductor substrate (11) is greater than or equal to 30% and less than or equal to 40%; and/or
the solar cell further comprises a third anti-reflection layer (25) formed on the second surface (13), wherein a surface reflectivity of the third anti-reflection layer (25) is greater than or equal to 20% and less than or equal to 30%; and/or
a reflectivity of the second surface (13) is greater than or equal to 30% and less than or equal to 60%;

11. The solar cell according to claim 10, wherein in a case that the solar cell further comprises the third anti-reflection layer (25), a ratio of the surface reflectivity of the third anti-reflection layer (25) to a surface reflectivity of the first anti-reflection layer (18) is greater than or equal to 5.

12. The solar cell according to claim 10, wherein in a case that the second doped semiconductor portion (17) is arranged on or in the second surface (13),
the first surface (12) of the semiconductor substrate (11) corresponds to a front surface of the solar cell; and/or
the solar cell further comprises a first finger (22), wherein the first finger (22) penetrates through the first anti-reflection layer (18) and is in ohmic contact with the first doped semiconductor portion (14); and an orthographic projection of the first finger (22) on the first surface (12) is located in the first region (15); and
wherein in a case that the solar cell comprises the first finger (22), the solar cell further comprises a first busbar (23) formed on the first anti-reflection layer (18), wherein the first busbar (23) is electrically connected to the first finger (22); and an orthographic projection of a partial region of the first busbar (23) on the first surface (12) is located in the second region (16).

13. The solar cell according to any one of claims 10 to 12, wherein the solar cell further comprises a first interface passivation layer (20) located between the first doped semiconductor portion (14) and the semiconductor substrate (11); and/or
when the second doped semiconductor portion (17) is formed on the semiconductor substrate (11), the solar cell further comprises a second interface passivation layer (21) located between the second doped semiconductor portion (17) and the semiconductor substrate (11); and
wherein in a case that the solar cell further comprises the first interface passivation layer (20) and the second interface passivation layer (21), a passivated contact type of a first passivation selective contact structure formed by the first interface passivation layer (20) and the first doped semiconductor portion (14) is different from a passivated contact type of a second passivation selective contact structure formed by the second interface passivation layer (21) and the second doped semiconductor portion (17).

14. A photovoltaic module, comprising the solar cell according to any one of claims 1 to 13.

15. The photovoltaic module according to claim 14, wherein in a case that the solar cell further comprises the second doped semiconductor portion (17), a conductivity type of the second doped semiconductor portion (17) is opposite to a conductivity type of the first doped semiconductor portion (14), and the second doped semiconductor portion (17) is arranged on or in the second surface (13),
the photovoltaic module comprises an inter-string conductive member connecting two adjacent solar cells in series, wherein an orthographic projection of a partial region of the inter-string conductive member arranged on the first surface (12) of the solar cell on the first surface (12) is located in the second region (16).
